# EUROPEAN PATENT APPLICATION

(11) **EP 2 675 252 A1**
(43) Date of publication of application: **18.12.2013**
(21) Application number: 12461523.8
(22) Date of filing: 13.06.2012
(51) Int. Cl.: H05K 3/34

(54) **A method for mounting an electronic element on a substrate with conductive paths sensitive to high temperature**

(71) Applicant: Polska Wytwornia Papierow Wartosciowych S.A., 00-222 Warszawa (PL)
(72) Inventor: Cieslak, Wojciech, 00-222 Warszawa (PL)
(74) Representative: Pawlowski, Adam

(57) **Abstract**

A method for mounting an electronic component on a substrate with conductive paths sensitive to high temperatures, characterized by applying solder (113) on the contact terminals (112) of the electronic component (111), heating the electronic component (111) to a temperature of at least the melting point the solder (113) and pressing the electronic component (111) towards the substrate (101) with conductive paths (102) while continuing the heating of the electronic component (111) until the solder (113) is bond with the conductive paths (102), and then stopping the heating of the electronic component (111).

## Description

The present invention relates to a method for mounting an electronic component on a substrate with conductive paths sensitive to high temperature. The invention is useful in particular in relation to flexible substrates with circuit paths printed thereon using conductive ink.

Flexible substrates, such as paper or plastic foil, may have electronic circuits printed thereon using inks which conduct electric current. This technology allows manufacturing various flexible products integrated with electronic components. When manufacturing such products, one of essential problems is how to connect electrically an electronic component, typically in form of a miniaturized integrated circuit mounted in a flip chip technology. Such chips cannot be mounted by technologies used typically for printed circuits made of a metal layer on a hard substrate, such as a typical Printed Circuit Board (PCB), wherein hot solder is applied to the printed circuit and electronic component is applied thereon, because the hot solder may damage the elastic layer as well as the conductive ink layer which has low resistance to temperature.

One of the methods typically used is to mount the electronic component without soldering, by contact only. An adhesive is applied to the central part of the electronic component and the electronic component is pressed towards the substrate such that its contact points touch the paths of the conductive ink. After the adhesive is cured, a relatively stable connection is achieved. However, such method complicates the overall manufacturing process, as it requires use of cold adhesives, which are characterized by a long curing time, typically from a dozen to several dozen minutes, and therefore it involves a long delay at the manufacturing line.

A European patent EP 0517071 discloses methods of joining components with a substrate in a "flip chip" technology. The first, typical method described is characterized by applying a thermosetting adhesive to the substrate and next pressing the component to the substrate, such that its contact points touch the paths, and then heating the adhesive. This may cause creation of bubbles in the adhesive and can be harmful to the substrate and to the conductive paths that have low resistance to temperature. The second method described is characterized by applying to the flexible substrate, positioned on an elastic tape, a thermosetting adhesive, and next pressing the electronic component and heating that component, simultaneously with bending the tape and pressing potential air bubbles outwards. Such a method involves heating of the adhesive via the electronic component at the time when the component is applied to the substrate, and therefore the substrate and the conductive paths are subject to high temperature for a long time, i.e. both when the electronic component is heated up and when it cools down. The temperature increases uniformly within the vicinity of the electronic component, which may cause destruction of the substrate or of the conductive paths made of conductive ink of low resistance to temperature, or it may require use of components which have a higher resistance to temperature.

A European patent EP 0804990 presents a method for mounting electronic components on a flexible substrate with low resistance to temperature (such as a polyester foil) with conductive paths made of copper, i.e. having relatively high temperature resistance. Solder is applied to the contact points of the conductive paths, the electronic component is applied on the solder and next the assembly is heated in a furnace. Protective plates are used to reflect the heat in places, where the solder does not need to be melted. Despite the majority of the substrate is protected by the plate, the heated part of the substrate requires quite high resistance to temperature, which is supported by the fact that the conductive paths are made of copper and not of conductive ink.

The aim of the present invention is to provide an alternative method for mounting electronic components on paths made of conductive ink, which would not require long delay at the manufacturing line and which would provide effective connection of the electronic component with the path made of conductive ink having low resistance to temperature.

The object of the invention is a method for mounting an electronic component on a substrate with conductive paths sensitive to high temperatures, comprising the steps of applying solder on the contact terminals of the electronic component, heating the electronic component to a temperature of at least the melting point the solder and pressing the electronic component towards the substrate with conductive paths while continuing the heating of the electronic component until the solder is bond with the conductive paths, and then stopping the heating of the electronic component.

Preferably, after the heating of the electronic component is stopped, the pressing of the electronic component towards the substrate is continued until the solder is cured.

Preferably, the substrate is a flexible substrate.

Preferably, the substrate is made of one of the materials selected from the group comprising: paper, polyester foil, PVC foil, polycarbonate foil.

Preferably, the conductive paths are made of conductive ink.

Preferably, as the solder there is used a substance having a melting point higher than the temperature, to which the substrate and/or conductive paths are sensitive.

Another object of the present invention is a substrate with conductive paths and an electronic circuit mounted to the substrate according to the method of the invention.

Another object of the present invention is a product formed as a laminate of a plurality of layers, from which at least one layer is a substrate with conductive paths and an electronic circuit according to the invention.

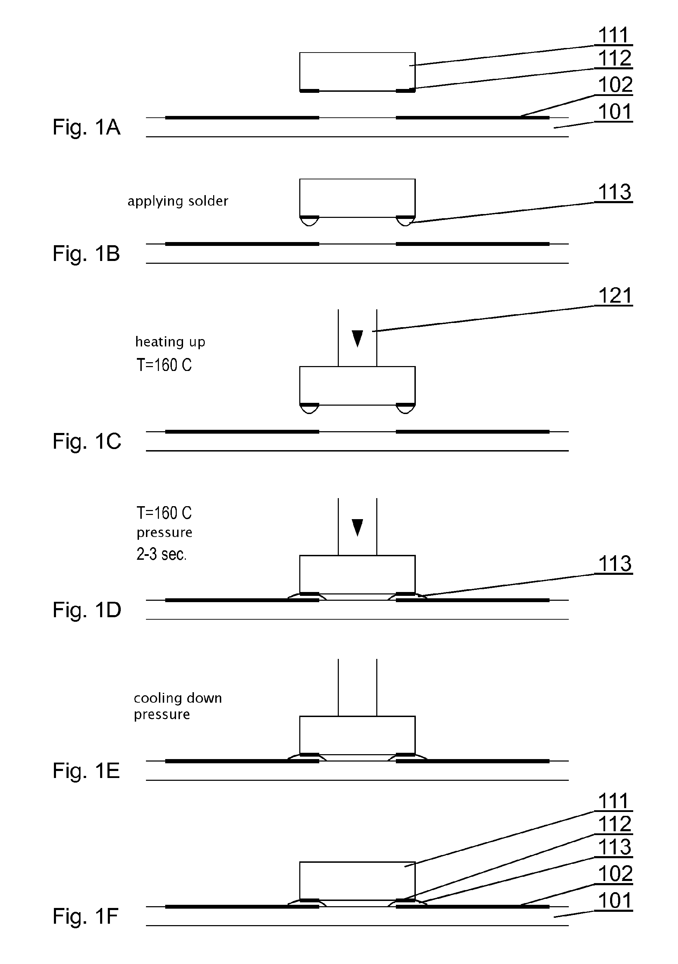

The object of the invention is shown by means of an exemplary embodiment on a drawing, in which Figs. 1A-1F show schematically the consecutive steps of the method according to the invention.

The method for mounting electronic components on paths made of conductive ink is shown schematically on Figs. 1A-1F. Fig. 1A shows a substrate 101 with printed paths 102 forming an electronic circuit on the substrate. The substrate 101 is preferably an elastic substrate having low resistance to temperature, for example it is formed of paper (having a carmelisation temperature of about 200°C), polyester foil (having a working temperature of about 155°C), PVC foil (having a working temperature of about 70°C), polycarbonate foil (having a working temperature of about 130°C). The paths 102 are preferably printed by conductive ink, for example conductive ink with silver particles having a sinterization temperature of about 21°C (curing time of 7 - 21 days) or a sinterization temperature of about 120°C - 130°C (curing time about 2 min - 10 min, and for sinterization temperature increased to about 160°C the curing time reduces to about 40s). The method according to the invention is therefore particularly useful for use with substrates and printed paths sensitive to high temperatures, i.e. such that have properties which are subject to disadvantageous changes, such as deformation or separation, when subject to such temperature for longer time. For example, the printed paths may be made by the following ink: CRSN2569 Sun Tronic 285 by SunChemical of Carlstardt, USA. The aim of the invention is to mount the electronic component 111 on the substrate 101 and to electrically connect the contact terminals 112 of the component with the paths 102 of the substrate.

First, solder 113 is applied on the contact terminals 112. The solder can be SnAg3,5 having a melting point of about 221°C or Sn60Pb40 having a melting point of about 183°C, as shown in Fig. 1B.

Next, using a heating holder 121 the component 111 is grabbed and its top surface is heated, thereby heating the whole component 111 together with its contact terminals 112 and the solder 113, to the melting temperature of the solder, i.e. about 221 °C or 183°C (depending on the solder applied), as shown in Fig. 1C.

In the following step, the heated component 111 is pressed towards the substrate 101, while keeping the heating for several seconds, such as to allow the molten solder 113 to bond with the conductive paths 102. The time is selected according to the amount of the solder 113, the parameters (thickness, width) of the paths 102 and the substrate 101, it is typically from 2 to 3 seconds, as shown in Fig. 1D. At this stage, the temperature of the substrate 101 and of the paths 102 gradually increases, but by stopping the heating after a short time the temperature does not increase above the sensitive temperature for the particular substrate 101 and paths 102.

Next, heating of the component 111 is stopped. The pressing of the component towards the substrate 101 can be continued, allowing the whole setup to be cooled down and therefore allowing the solder 113 to bond the component 111 with the substrate 101, as shown in Fig. 1E.

As a result, the component 111 is mechanically and electrically attached to the substrate 101 with conductive paths 102. As the substrate 101 and the paths 102 are subject to high temperature only temporarily, it does not cause changes in their structures and the component can be securely attached. The product obtained by the method according to the invention is characterized by high durability of connection of the electronic component to the conductive paths. Products with flexible substrates can be used as a component of a product comprising a laminate of several layers, such as electronic cards.

## Claims

**1.** A method for mounting an electronic component on a substrate with conductive paths sensitive to high temperatures, **characterized by** applying solder (113) on the contact terminals (112) of the electronic component (111), heating the electronic component (111) to a temperature of at least the melting point the solder (113) and pressing the electronic component (111) towards the substrate (101) with conductive paths (102) while continuing the heating of the electronic component (111) until the solder (113) is bond with the conductive paths (102), and then stopping the heating of the electronic component (111).

**2.** The method according to claim 1, **characterized in that** after the heating of the electronic component (111) is stopped, the pressing of the electronic component (111) towards the substrate (101) is continued until the solder (113) is cured.

**3.** The method according to claim 1 or 2, **characterized in that** the substrate is a flexible substrate.

**4.** The method according to any of previous claims, **characterized in that** the substrate is made of one of the materials selected from the group comprising: paper, polyester foil, PVC foil, polycarbonate foil.

**5.** The method according to any of previous claims, **characterized in that** the conductive paths are made of conductive ink.

**4.** Sposób wedlug dowolnego z wcze 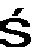 niejszych zastrzezeże 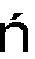 , znamienny tym, że podloże jest wykonane z jednego z materialów wybranych z grupy zawierajacej: papier, folia poliestrowa, folia PVC, folia poliweglanowa.

**6.** The method according to any of previous claims, **characterized in that** as the solder (113) there is used a substance having a melting point higher than the temperature, to which the substrate (101) and/or conductive paths (102) are sensitive.

**7.** A substrate with conductive paths and an electronic circuit mounted to the substrate according to the method of any of claims 1-6.

**8.** A product formed as a laminate of a plurality of layers, from which at least one layer is a substrate with conductive paths and an electronic circuit according to claim 7.
